# EUROPEAN PATENT APPLICATION

(11) **EP 4 411 810 A1**
(43) Date of publication of application: **07.08.2024**
(21) Application number: 22878467.4
(22) Date of filing: 03.10.2022
(51) Int. Cl.: H01L 23/373, H01L 23/36, H05K 7/20

(54) **HEAT DISSIPATION MEMBER**

(30) Priority: 06.10.2021 JP 2021164570
(71) Applicant: Denka Company Limited, Tokyo 103-8338 (JP)
(72) Inventor: GOTO, Daisuke, Tokyo 103-8338 (JP); OTA, Hiroaki, Tokyo 103-8338 (JP); KOYANAGI, Kazunori, Tokyo 103-8338 (JP); FUNATSU, Nobuhiro, Tokyo 103-8338 (JP)
(74) Representative: Gulde & Partner
(86) International application number: PCT/JP2022/036942
(87) International publication number: WO 2023/058598

(57) **Abstract**

Provided is a heat dissipation member according to the present invention including a flat metal-silicon carbide composite containing aluminum, in which a thickness of the heat dissipation member is equal to or less than 4 mm, and the heat dissipation member is used as a heat dissipation member for automobile mount.

## Description

### TECHNICAL FIELD

The present invention relates to a heat dissipation member.

### BACKGROUND ART

Various heat dissipation members have been developed until now. As this kind of technique, for example, a technique described in Patent Document 1 is known. Patent Document 1 describes a power conversion device of a railroad vehicle, the power conversion device including: a plurality of power semiconductor elements; and a heat receiving member, in which the plurality of power semiconductor elements are attached to one surface side of the heat receiving member (claim 1 of Patent Document 1).

In addition, Patent Document 1 describes that the heat receiving member is formed of, for example, a metal such as an aluminum alloy, iron, or copper, and the power semiconductor elements are fixed to one surface (upper surface) of the heat receiving member using a screw or the like through a member such as a grease (paragraphs 0021 and 0023 of Patent Document 1 and the like).

### RELATED DOCUMENT

### PATENT DOCUMENT

[Patent Document 1] Japanese Unexamined Patent Publication No. 2020-171196

### SUMMARY OF THE INVENTION

### TECHNICAL PROBLEM

However, as a result of an investigation by the present inventors, it was found that the heat receiving member of the railroad vehicle described in Patent Document 1 has room for improvement from the viewpoints of thinning and heat dissipation for use in an automobile.

### SOLUTION TO PROBLEM

Recently, for components mounted on an automobile, a demand for a reduction in thickness or height has been increased.

As a result of further investigation, the present inventors found that, by thinning and using a metal-silicon carbide composite having low thermal expansion and a high thermal conductivity, a heat dissipation member having a small thickness and excellent heat dissipation characteristics can be realized, and this heat dissipation member can be suitably used as a heat dissipation member for automobile mount, thereby completing the present invention.

According to one aspect of the present invention, a heat dissipation member described below is provided.
1. A heat dissipation member including a flat metal-silicon carbide composite containing aluminum,
   in which a thickness of the heat dissipation member is equal to or less than 4 mm, and
   the heat dissipation member is used as a heat dissipation member for automobile mount.
2. The heat dissipation member according to 1,
   in which when seen from a direction perpendicular to a main surface, vertical and horizontal lengths are equal to or less than 200 mm × equal to or less than 150 mm.
3. The heat dissipation member according to 1 or 2,
   in which an arithmetic mean roughness Ra in a main surface is equal to or more than 0.1 um and equal to or less than 2.0 um.
4. The heat dissipation member according to any one of 1 to 3,
   in which an average length Rsm of roughness curve elements in a main surface is equal to or more than 50 um and equal to or less than 400 µm.
5. The heat dissipation member according to any one of 1 to 4,
   in which a flatness in a main surface is equal to or more than 5 um and equal to or less than 700 µm.
6. The heat dissipation member according to any one of 1 to 5,
   in which an amount of warpage is equal to or more than 5 um and equal to or less than 700 µm.
7. The heat dissipation member according to any one of 1 to 6, further including:
   a plating layer that is formed on a main surface side of the heat dissipation member.
8. The heat dissipation member according to 7,
   in which an arithmetic mean roughness Ra in a surface of the plating layer is equal to or more than 0.1 um and equal to or less than 2.0 µm.
9. The heat dissipation member according to 7 or 8,
   in which an average length Rsm of roughness curve elements in a surface of the plating layer is equal to or more than 50 um and equal to or less than 400 µm.
10. The heat dissipation member according to any one of 7 to 9,
   in which the plating layer is formed of a Ni plating layer.
11. The heat dissipation member according to any one of 1 to 10, further comprising:
   a metal layer that is formed on a main surface of the heat dissipation member and contains aluminum.
12. The heat dissipation member according to any one of 1 to 11,
   in which an average thermal expansion coefficient of the heat dissipation member at 25°C to 150°C is equal to or more than 4 ppm/K and equal to or less than 12 ppm/K.
13. The heat dissipation member according to any one of 1 to 12,
   in which a thermal conductivity of the heat dissipation member in a plate thickness direction at 25°C is equal to or more than 150 W/m·K and equal to or less than 300 W/m·K.

### ADVANTAGEOUS EFFECTS OF INVENTION

According to the present invention, a heat dissipation member having a small thickness and excellent heat dissipation is provided.

### BRIEF DESCRIPTION OF THE DRAWINGS

Fig. 1 is a diagram (a perspective view, a cross-sectional view) schematically showing an example of a heat dissipation member.
Fig. 2 is a diagram showing a measuring method.

### DESCRIPTION OF EMBODIMENTS

Hereinafter, an embodiment of the present invention will be described using the drawings. In all of the drawings, same components will be represented by same reference numerals, and the description thereof will be omitted where appropriate. In addition, the diagrams are schematic diagrams, in which a dimensional ratio does not match the actual one.

In the present specification, unless explicitly specified otherwise, the term "substantially" in the present specification is intended to include a range defined in consideration of manufacturing tolerances, assembly variations, and the like.

Unless specified otherwise, a value measured at room temperature (25°C) can be adopted as a value that is variable depending on temperatures among various numerical values (in particular, measured values) in the present specification.

In the present specification, "to" represents that an upper limit value and a lower limit value are included unless specified otherwise.

A heat dissipation member according to the present embodiment will be outlined.

The heat dissipation member according to the present embodiment is used as a heat dissipation component for automobile mount, including a flat metal-silicon carbide composite containing aluminum, in which a thickness of the heat dissipation member is equal to or less than 4 mm.

The heat dissipation member according to the present embodiment is used as a heat dissipation component for dissipating heat from an electronic component mounted on an automobile such as an electric vehicle. In the component mounted on the automobile, a demand for a reduction in thickness or height has increased. The heat dissipation member according to the present embodiment has a low thermal resistance and a small thickness, and thus can be suitably used for use of the automobile mount.

In addition, the heat dissipation member can be used as a heat dissipation component for a power module of electronic components including a power semiconductor element or the like. Examples of the electronic components include an electric conversion device such as an inverter device.

A main surface of the heat dissipation member may be bonded to electronic components including a ceramic plate or the like.

On the other hand, in order to improve heat dissipation of heat generated from the electronic components, another surface of the heat dissipation member may be bonded to another heat dissipation component such as a heat dissipation fin or a heat dissipation unit.

The details of the heat dissipation member according to the present embodiment will be described.

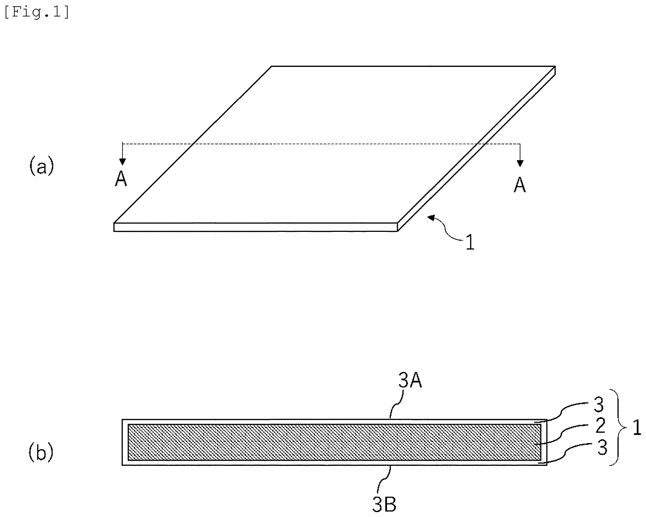

Fig. 1(a) is a perspective view schematically showing an example of the heat dissipation member, and Fig. 1(b) is a cross-sectional view taken along arrow A-A of Fig. 1(a).

A heat dissipation member 1 in Fig. 1 includes a flat metal-silicon carbide composite 2 and a metal layer 3 that is formed on at least both front and back surfaces of the metal-silicon carbide composite 2.

Among both of the two surfaces of the heat dissipation member 1, a surface on a side where an electronic component is mounted is represented by a main surface 3A, and another surface thereof is represented by a back surface 3B.

In one aspect, the main surface 3A and/or the back surface 3B (that is, the surface of the heat dissipation member 1) may be the metal-silicon carbide composite 2 containing aluminum.

In another aspect, the main surface 3A and/or the back surface 3B (the surface of the heat dissipation member 1) may be the metal layer 3. For example, it is preferable that the main surface 3A and/or the back surface 3B of the heat dissipation member 1 includes the metal layer 3 (surface metal layer) containing aluminum. In this case, a portion of the heat dissipation member 1 other than the surface metal layer can be the metal-silicon carbide composite or the like.

The electronic components may include an electronic circuit and a ceramic plate. The electronic component is mounted on the main surface 3A side of the heat dissipation member 1, for example, by being bonded using a solder or a brazing material.

Another heat dissipation component (for example, a heat dissipation fin) is mounted on the back surface 3B side of the heat dissipation member 1, for example, by being bonded using a solder or a brazing material. In this case, the heat dissipation member 1 does not need to have a screw hole for insertion of a screw for bonding the other heat dissipation component.

The heat dissipation member 1 is preferably substantially rectangular. That is, the shape of the heat dissipation member 1 is substantially rectangular when seen from a direction perpendicular to the main surface 3A of the heat dissipation member 1.

Here, "being substantially rectangular" represents that at least one of four corners of the heat dissipation member 1 may have a slightly rounded shape without being linear (of course, the four corners may be linear).

When at least one of the four corners of the heat dissipation member 1 is processed in a rounded shape, an intersection point when straight line portions of a short side and a long side of the heat dissipation member 1 in the top view are extended can be defined as "vertex" of the rectangle. In addition, at this time, "the length of the short side" or "the length of the long side" of the heat dissipation member 1 can be defined by using the above-described "vertex" as a starting point or an end point.

In a cross-sectional view of the heat dissipation member 1, the thickness of the heat dissipation member 1 is equal to or less than 4 mm, preferably 0.8 to 3 mm, and more preferably 1 to 2 mm. By thinning the heat dissipation member 1 up to equal to or less than the upper limit value, a thermal resistance can be reduced, and a reduction in weight of the heat dissipation member 1 can be realized.

When the thickness of the heat dissipation member 1 is not uniform, it is preferable that at least the thickness of a center-of-gravity portion of the heat dissipation member 1 is in the above-described range.

When seen from the direction perpendicular to the main surface 3A of the heat dissipation member 1, vertical and horizontal lengths of the heat dissipation member 1 are, for example, 10 mm × 10 mm to 200 mm × 150 mm.

An arithmetic mean roughness Ra (hereinafter, also referred to as "surface roughness Ra") in the main surface 3A and/or the back surface 3B of the heat dissipation member 1 is, for example, 0.1 to 2.0 um and more preferably 0.2 to 1.6 um.

As a result, the heat dissipation can be further improved. It is considered that, by appropriately setting the value of the surface roughness Ra, the wettability of the solder or the brazing material can be improved, and the bond strength with the electronic component and/or the other heat dissipation component can be improved.

An average length Rsm of roughness curve elements (hereinafter, also referred to as "average length Rsm") in the main surface 3A and/or the back surface 3B of the heat dissipation member 1 is, for example, 50 to 400 um and more preferably 60 to 350 um.

As a result, the heat dissipation can be further improved. It is considered that, by appropriately setting the value of the average length Rsm, micro gaps can be reduced, and the bond strength with the electronic component and/or the other heat dissipation component can be improved.

The surface roughness Ra or the average length Rsm is measured according to ISO 4287-1997, and an exposed portion where the electronic component or the other heat dissipation component is not mounted is set as a measuring surface.

A flatness in the main surface 3A and/or the back surface 3B of the heat dissipation member 1 is, for example, 5 to 700 um, preferably 10 to 600 µm, and more preferably 30 to 500 um.

When the heat dissipation member 1 is bonded to the electronic component and/or the other heat dissipation member, the bondability is improved, and excellent heat dissipation performance can be obtained.

The flatness is defined as the distance between two parallel planes in a case where the distance between the two parallel planes is the smallest when a flat shape is interposed between two geometrically parallel planes (refer to JIS B 0621) .

An example of a flatness measuring apparatus is the VR-3000 apparatus manufactured by Keyence Corporation.

The amount of warpage in the main surface 3A and/or the back surface 3B of the heat dissipation member 1 is, for example, 5 to 700 um, preferably 10 to 600 µm, and more preferably 30 to 500 µm.

An average thermal expansion coefficient of the heat dissipation member 1 at 25°C to 150°C is, for example, 4 to 12 ppm/K and preferably 4 to 10 ppm/K. As a result, cracking, fracturing, or the like caused by a difference in thermal expansion coefficient from the ceramic plate can be suppressed.

The linear thermal expansion coefficient can be measured by a thermal expansion meter according to JIS R1618 under a condition of a temperature increase rate of equal to or lower than 5 °C/min, and a value during a temperature increase from 25°C to 150°C is used.

The thermal conductivity of the heat dissipation member 1 in the plate thickness direction at 25°C is, for example, 150 to 300 W/m·K and preferably 180 to 300 W/m·K.

The thermal conductivity can be measured using a laser flash method according to JIS R1611.

The metal in the metal-silicon carbide composite 2 may be, for example, aluminum, an aluminum alloy, magnesium, or a magnesium alloy. From the viewpoint of the thermal conductivity, it is preferable that the metal-silicon carbide composite 2 contains aluminum or an aluminum alloy.

In addition, examples of the alloy include an aluminum alloy containing 7 to 25 mass% of silicon (Si) . By using the aluminum alloy containing 7 to 25 mass% of silicon, an effect of promoting densification of the metal-silicon carbide composite 2 can be obtained.

When the metal-silicon carbide composite 2 is an aluminum-silicon carbide composite, the metal contains aluminum as a main component, and the content of aluminum in the metal is, for example, 60 to 100 mass% and may be 70 to 99.8 mass%.

In addition to aluminum as the main component, the metal in the aluminum-silicon carbide composite may contain one or two or more elements selected from the group consisting of magnesium, silicon, iron, and copper as long as the effect of the present invention does not deteriorate.

The metal in the metal layer 3 may be the same as the metal contained in the metal-silicon carbide composite 2, for example, aluminum, an aluminum alloy, magnesium, or a magnesium alloy.

The thickness of the metal layer 3 is, for example, 10 to 300 um and preferably 30 to 150 um.

By adjusting the thickness of the metal layer 30 to be equal to or more than the lower limit value, the film strength of the metal layer 3 can be improved. By adjusting the thickness of the metal layer 3 to be equal to or less than the upper limit value, the occurrence of warpage caused by a difference in thermal expansion coefficient from the metal-silicon carbide composite 2 can be suppressed.

The material of the ceramic plate in the electronic component is not particularly limited as long as it is a ceramic material.

Examples of the material of the ceramic plate include a nitride ceramic such as silicon nitride or aluminum nitride, an oxide ceramic such as aluminum oxide or zirconium oxide, a carbide ceramic such as silicon carbide, and a boride ceramic such as lanthanum boride. Among these, aluminum nitride, silicon nitride, and aluminum oxide are preferable from the viewpoints of insulation properties, the strength of bonding to the metal layer 13, mechanical strength, and the like.

As a brazing material that bonds the metal layer 3 and the ceramic plate to each other, an Ag-Cu-based brazing material is preferable. That is, the brazing material is preferably a mixture of Ag powder, Cu powder, and the like.

The brazing material may contain Sn or In, for example, in order to improve wettability with the ceramic plate or the like.

It is preferable that the brazing material contains active metal, for example, from the viewpoint of increasing reactivity with the ceramic plate. Examples of the active metals include titanium, zirconium, hafnium, and niobium. It is preferable that the brazing material contains titanium from the viewpoint of improving reactivity with an aluminum nitride substrate and a silicon nitride substrate and significantly improving the bond strength to them.

In addition, the type of the solder is not particularly limited and, for example, a lead-tin eutectic solder or a lead-free solder can be used.

Although not shown in Fig. 1, the heat dissipation member 1 may include a plating layer that is formed on the main surface 3A side of the heat dissipation member 1, specifically, the outermost surface. As a result, the solder bondability can be improved.

The plating layer may contain at least one of Ni, Au, and Ag. In particular, it is preferable that the plating layer is formed of an Ni plating layer containing Ni.

The thickness of the plating layer is, for example, 3 to 15 um and preferably 4 to 10 um.

By adjusting the thickness of the plating layer to be equal to or more than the lower limit value, the film stability of the plating layer can be improved. By adjusting the thickness of the plating layer to be equal to or less than the upper limit value, the occurrence of warpage caused by a difference in thermal expansion coefficient from an underlayer such as the metal layer 3 can be suppressed.

An arithmetic mean roughness Ra in a surface B of the plating layer is, for example, 0.1 to 2.0 um and more preferably 0.2 to 1.6 um.

As a result, the heat dissipation can be further improved. It is considered that, by appropriately setting the value of the surface roughness Ra, the wettability of the solder or the brazing material can be improved, and the bond strength with the electronic component and/or the other heat dissipation component can be improved.

An average length Rsm of roughness curve elements in the surface of the plating layer is, for example, 50 to 400 um and more preferably 60 to 350 um.

As a result, the heat dissipation can be further improved. It is considered that, by appropriately setting the value of the average length Rsm, micro gaps can be reduced, and the bond strength with the electronic component and/or the other heat dissipation component can be improved.

A method of manufacturing the heat dissipation member will be described.

An example of the method of manufacturing the heat dissipation member includes: a preparation step of forming a flat porous silicon carbide body (SiC preform) ; and an impregnation step of impregnating the porous silicon carbide body with metal (an alloy) to prepare a metal-silicon carbide composite that includes a composite portion containing silicon carbide and the metal.

In the preparation step, a method of manufacturing the porous silicon carbide body (SiC preform) is not particularly limited, and the porous silicon carbide body can be manufactured using a well-known method. For example, the porous silicon carbide body can be manufactured by adding silica, alumina, or the like as a binder to silicon carbide (SiC) powder as a raw material, mixing the components, molding and calcinating the mixture at equal to or higher than 800°C.

As a method of forming the porous silicon carbide body in a flat shape, a well-known method can be appropriately applied. For example, a well-known method such as a dry press method, a wet press method, an extrusion molding method, an injection method, a casting method, or a method of punching out after sheet-molding can be used.

It is preferable that the SiC content in the porous silicon carbide body is high because the thermal conductivity is high and the thermal expansion coefficient is low. It is noted that, when the content is excessively high, there is a case that the porous silicon carbide body is not sufficiently impregnated with an aluminum alloy.

In practice, suitably, the porous silicon carbide body contains equal to or higher than 40 mass% of coarse SiC particles having an average particle size of preferably equal to or more than 40 um, and the relative density of the SiC preform is preferably in a range of 55 to 75%.

The bending strength of the porous silicon carbide body (SiC preform) is preferably equal to or higher than 3 MPa in order to prevent the porous silicon carbide body from fracturing during handling or impregnation. The average particle size can be measured by calculating the average value of particle sizes of 1000 particles using a scanning electron microscope (for example, "JSM-T200 model", manufactured by JEOL Ltd.) and an image analyzer (for example, manufactured by Nippon Avionics Co., Ltd.). In addition, the relative density can be measured by Archimedes method, etc.

It is preferable that the particle size of the SiC powder as a raw material of the porous silicon carbide body (SiC preform) is adjusted by, for example, appropriately using coarse powder and fine powder in combination. As a result, both the strength of the porous silicon carbide body (SiC preform) and the high thermal conductivity of the heat dissipation member that is finally obtained can be improved.

Specifically, mixed powder obtained by mixing (i) SiC coarse powder having an average particle size of 40 to 150 um and (ii) SiC fine powder having an average particle size of 5 to 15 um is suitable. Here, regarding a ratio between the amount of (i) and the amount of (ii) in the mixed powder, the amount of (i) is preferably 40 to 80 mass%, and the amount of (ii) is preferably 20 to 60 mass%.

The porous silicon carbide body (SiC preform) is obtained by, for example, degreasing and calcinating a compact of a mixture obtained by adding the binder to the SiC powder. When the calcination temperature is equal to or higher than 800°C, a porous silicon carbide body (SiC preform) having a bending strength of equal to or higher than 3 MPa is likely to be obtained irrespective of the atmosphere during the calcination.

It is noted that, in an oxidizing atmosphere, when the calcination is performed at a temperature exceeding 1100°C, oxidation of SiC is promoted, and there is a case that the thermal conductivity of the metal-silicon carbide composite decreases. Accordingly, it is preferable that the calcination is performed at a temperature of equal to or lower than 1100°C in the oxidizing atmosphere.

The calcination time may be appropriately determined depending on conditions such as the size of the porous silicon carbide body (SiC preform), the amount of raw materials charged into a calcination furnace, or the calcination atmosphere.

When the porous silicon carbide body (SiC preform) is molded in a predetermined shape, a change in curve caused by drying can be prevented by performing drying the SiC preforms one by one or by performing drying the SiC preforms using a spacer such as carbon having the same shape as the preform shape between the SiC preforms. In addition, by performing the same process as that during drying for the calcination, a shape change caused by a change in internal structure can be prevented.

As necessary, at least a single surface of the porous silicon carbide body (SiC preform) is processed in a convex curved shape toward the outer side by, for example, a cutting and grinding tool such as a lathe. Both surfaces of the porous silicon carbide body (SiC preform) may be processed instead of the single surface.

In this way, by performing mechanical processing (cutting) at a stage of the preform, it is not necessary to use, for example, a special tool for cutting after the metal impregnation, and there is an advantageous effect in that the degree of curve or the flatness is easy to control.

The thickness of the flat porous silicon carbide body may be adjusted to be equal to or less than 4 mm during molding before calcination. The thickness of the flat porous silicon carbide body may be adjusted by a thinning treatment such as grinding after calcination. From the viewpoint of manufacturing stability with respect to cracking, fracturing, or the like, a method of adjusting the thickness during molding is preferable.

The vertical and horizontal dimensions of the flat porous silicon carbide body may be adjusted during molding before calcination but may also be adjusted by outer periphery processing after calcination or after metal impregnation.

Next, in the impregnation step, the porous silicon carbide body (SiC preform) can be impregnated with metal containing aluminum using a high-pressure forging method or the like to prepare a metal-silicon carbide composite including a composite portion and a surface metal layer, the composite portion containing silicon carbide and metal, and the surface metal layer being provided on an outer surface of the composite portion.

Examples of a method of obtaining the metal-silicon carbide composite by impregnating the porous silicon carbide body (SiC preform) with the metal (alloy) containing aluminum include the following method.

The porous silicon carbide body (SiC preform) is put into a mold, and one or more kinds among fibers, spherical particles, and crushed particles formed of alumina or silica are disposed to be in direct contact with on both plate surfaces of the mold. As a result, one block is obtained.

This block is preheated to 500 to 650°C, and one or two or more blocks are disposed in a high-pressure container. Next, in order to prevent a temperature decrease of the block, as rapidly as possible, molten metal containing aluminum is pressurized at a pressure of equal to or higher than 30 MPa, and the metal is impregnated into voids of the porous silicon carbide body (SiC preform).

As a result, the metal-silicon carbide composite including the composite portion and the surface metal layer is obtained, the composite portion containing silicon carbide and metal, and the surface metal layer being provided on the outer surface of the composite portion.

It is preferable that the melting point of the metal (typically, aluminum or an alloy containing aluminum) in the metal-silicon carbide composite is as low as possible so as to allow the metal to sufficiently permeate into the voids of the preform during the impregnation.

From this viewpoint, for example, an aluminum alloy containing equal to or higher than 7 mass% and equal to or lower than 25 mass% of silicon is preferable. Metal components in the aluminum alloy other than aluminum and silicon are not particularly limited within a range where characteristics of the aluminum alloy do not change extremely. For example, copper may be contained.

As the metal, magnesium or an alloy containing magnesium may be used instead of aluminum or the alloy containing aluminum.

As the aluminum alloy, for example, AC4C, AC4CH, or ADC12 that is an alloy for forging can be preferably used.

In order to remove distortion generated during the impregnation, an annealing treatment may be performed after the preparation of the metal-silicon carbide composite. It is preferable that the annealing treatment that is performed in order to remove the distortion is performed at a temperature of 400 to 550°C for 10 minutes to 5 hours.

When the annealing temperature is equal to or higher than 400°C, the distortion in the composite is sufficiently released, and a significant change in curve in the annealing treatment step after mechanical processing can be suppressed. On the other hand, when the annealing temperature is equal to or lower than 550°C, the aluminum alloy used for the impregnation can be prevented from melting.

When the annealing time is 10 minutes or longer, the distortion in the composite is sufficiently released, and a significant change in curve in the annealing treatment step for removing processing strain after mechanical processing can be suppressed. On the other hand, it is preferable that the annealing time is 5 hours or shorter from the viewpoint of mass productivity or the like.

In addition, for example, one or more kinds among fibers, spherical particles, and crushed particles formed of alumina or silica can be disposed to be in direct contact with the surface of the porous silicon carbide body (SiC preform) . As a result, a surface metal layer having a predetermined thickness can be formed. There is advantageous effects in that the metal-silicon carbide composite has substantially no color unevenness after the impregnation, and in that workability during shaping can be improved.

The content of the material including one or more kinds among fibers, spherical particles, and crushed particles formed of alumina or silica in the surface metal layer is preferably 0.1 to 5 mass% and more preferably 0.3 to 2 mass% with respect to the mass of the metal-silicon carbide composite.

When the content is equal to or higher than 0.1 mass%, it is easy to control the thickness of the aluminum layer, and a significant change in curved shape caused by the annealing treatment after processing can be suppressed. In addition, when the content is equal to or lower than 5 mass%, the aluminum alloy layer is not excessively hard, and general mechanical processing can be easily performed on the composite.

Optionally, at least the surface metal layer on the surface side processed in a convex curved shape in the metal-silicon carbide composite may be mechanically processed and, in some cases, may be further annealed.

Specifically, an appropriate curved shape is formed on the heat dissipation surface of the metal-silicon carbide composite using a tool such as a lathe capable of accurate scraping (for example, grinding or cutting) . Next, for example, the metal-silicon carbide composite is heated at about 400 to 550°C using a muffle furnace and is annealed for about 2 to 6 hours.

As a result, the heat dissipation member according to the present embodiment can be obtained.

Of course, the method of manufacturing the heat dissipation member according to the present embodiment is not limited to the above-described configuration.

For example, in the heat dissipation member according to the present embodiment, the surface metal layer is an optional configuration. Therefore, the surface metal layer does not need to be formed.

In addition, a step of polishing or blasting the surface of the obtained heat dissipation member may be performed. As a specific method of the polishing treatment or the blasting treatment, a well-known method can be appropriately applied.

In the present embodiment, for example, by appropriately selecting the method of manufacturing the heat dissipation member, specifically, the metal-silicon carbide composite, the arithmetic mean roughness Ra, the average length Rsm of roughness curve elements, the flatness, and the amount of warpage in the main surface of the heat dissipation member can be controlled. In particular, for example, appropriately controlling a grinding treatment or polishing conditions on the porous silicon carbide body or performing the annealing treatment after preparing the metal-silicon carbide composite is an element for adjusting Ra, Rsm, the flatness, and the amount of warpage to the desired numerical ranges.

As the outer periphery processing, for example, typical mechanical processing, grinding, water-jet machining, laser processing, or electric discharge machining is used, but the present invention is not limited thereto.

In addition, in the obtained heat dissipation member 1, a plating layer may be provided by performing a plating step. For example, the plating layer can be provided on the surface of the heat dissipation member using a well-known method of electroless Ni-P plating or Ni-B plating.

Hereinafter, the embodiment of the present invention has been described. However, the embodiment is merely an example of the present invention, and various configurations other than the above-described configurations can be adopted. In addition, the present invention is not limited to the above-described embodiments, and modifications, improvements, and the like within a range where the object of the present invention can be achieved are included in the present invention.

### Examples

Hereinafter, the present invention will be described in detail with reference to Examples. However, the present invention is not limited to the description of these Examples.

### <Manufacturing of Heat Dissipation Member>

### [Example 1]

### (Formation of Porous Silicon Carbide Body)

First, silicon carbide powder A, silicon carbide powder B, and silica sol described below were mixed with each other using a stirring mixer for 30 minutes to obtain a mixture.
·Silicon carbide powder A (manufactured by Pacific Rundum Co., Ltd.: NG-150, average particle size: 100 um) 300 g
·Silicon carbide powder B (manufactured by Yakushima Denko Co., Ltd.: GC-1000F, average particle size: 10 um) 150 g
·Silica sol (manufactured by Nissan Chemical Operation: SNOWTEX) 30 g

The obtained mixture was put into a mold and was pressed at a pressure of 10 MPa. As a result, a flat compact having a dimension of 185 mm × 135 mm × 3 mm was obtained. The obtained compact was calcinated in air at a temperature of 900°C for 2 hours to obtain a porous silicon carbide body having a relative density (bulk density) of 65 vol%.

A surface of the porous silicon carbide body forming the back surface 3B of the heat dissipation member after completion was processed with a surface grinding machine.

For the following step, 30 porous silicon carbide bodies having the same configuration were prepared.

### (Impregnation with Metal)

Both surfaces of the surface-ground porous silicon carbide body were interposed between carbon-coated stainless steel plates having a dimension of 210 mm × 160 mm × 0.8 mm, and 30 porous silicon carbide bodies were laminated.

Next, steel plates having a thickness of 6 mm were disposed on the both sides and were fastened by six M10 bolts in a state that they were lined to each other using a torque wrench such that the fastening torque in a planar direction was 2 Nm. As a result, one block was obtained.

Next, the integrated block was preheated to 620°C in an electric furnace and subsequently was put into a press mold having an inner diameter of 400 mmϕ that was heated in advance. Molten aluminum alloy containing 12 mass% of silicon and 1.2 mass% of magnesium was poured into the press mold, and the mold was pressurized at a pressure of 60 MPa for 20 minutes. As a result, the porous silicon carbide body was impregnated with the aluminum alloy.

After completion of the impregnation, the block was cooled to 25°C and was cut along a shape of the stainless steel plates using a wet bandsaw to remove the interposed stainless steel plates. Further, next, in order to remove distortion during the impregnation, an annealing treatment was performed at a temperature of 500°C for 3 hours.

As a result, an aluminum-silicon carbide composite was obtained.

### (Treatment after Impregnation)

The outer periphery of the obtained aluminum-silicon carbide composite was processed with an NC lathe such that the vertical and horizontal lengths were 190 mm × 140 mm.

The obtained aluminum-silicon carbide composite was cut into a size of 35 mm × 35 mm by laser processing.

As a result, a heat dissipation member including no plating layer was obtained.

Further, the aluminum-silicon carbide composite was blasted and cleaned with alumina abrasive grains under conditions of pressure: 0.4 MPa, transport speed: 1.0 m/min. Next, electroless Ni-P plating and Ni-B plating were performed on the composite. As a result, a plating layer having a thickness of 8 um (Ni-P: 6 um, Ni-B: 2 µm) was formed on the surface of the composite.

As a result, a heat dissipation member including the plating layer was obtained.

### [Examples 2 to 10]

In Examples 2 to 10, heat dissipation members were prepared in the same steps as that of Example 1, except that the grinding conditions (thinning treatment after calcination) of the surface grinding machine were changed, a treatment of forming a curved shape on the surface by more accurate grinding is, as necessary, performed under predetermined conditions, and/or a polishing treatment is performed under predetermined conditions after the thinning treatment. Next, various numerical values were measured using the same methods as those of Example 1.

### (Ra, Rsm)

In the main surface 3A of each of the heat dissipation member including no plating layer and the heat dissipation member including the plating layer, the arithmetic mean roughness Ra and the average length Rsm of roughness curve elements were measured using a device SJ-310 (manufactured by Mitutoyo Corporation) according to ISO4287-1997.

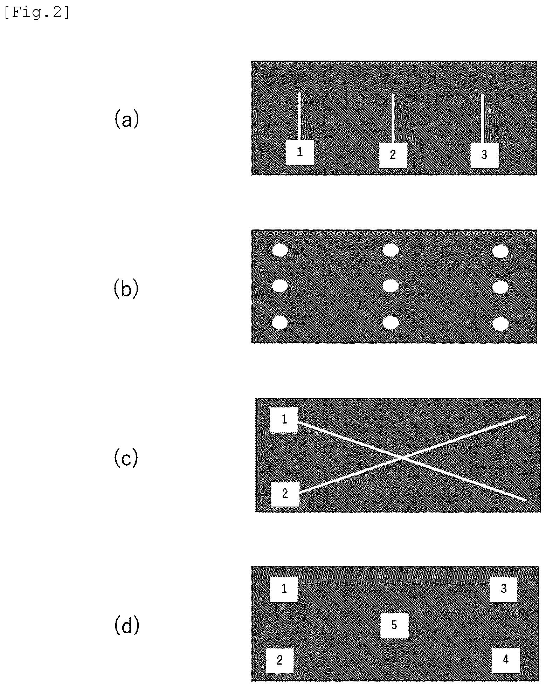

As shown in Fig. 2(a), the measurement of Ra and Rsm was performed at three positions.

### (Flatness)

In the main surface 3A of the heat dissipation member including no plating layer, the flatness was measured using the device XYZAX (manufactured by Tokyo Seimitsu Co., Ltd.). At this case, the flatness was measured such that the center (geometric center of gravity) of the main surface 3A in a top view matches the center of the field of view of the measuring device.

### (Amount of Warpage)

In the heat dissipation member including no plating layer, the amount of warpage was measured using a contour shape measuring machine (manufactured by Tokyo Seimitsu Co., Ltd.; CONTOUR RECORD 1600D).

As shown in Fig. 2(c), the measurement of the amount of warpage was performed in a diagonal line shape with a width of 30 mm.

### (Thickness)

In the heat dissipation member including no plating layer, the thickness was measured using a micrometer.

As shown in Fig. 2(d), the measurement of the thickness was performed at five positions.

### (Thermal Conductivity and Thermal Expansion Coefficient)

The thermal conductivity was measured using a laser flash method according to JIS R1611.

The linear thermal expansion coefficient was measured by a thermal expansion meter according to JIS R1618 under a condition of a temperature increase rate of equal to or lower than 5 °C/min, and a value during a temperature increase from 25°C to 150°C was used.

### [Table 1]

**Table 1**

| | Example | Ra (µm) | | | Rsm (µm) | | | Flatness (µm) | Warpage (µm) | | Thickness (mm) | | | | | Thermal Conductivity (W/mK) | Thermal Expansion Coefficient (10⁻⁶/K) |
|---|---|---|---|---|---|---|---|---|---|---|---|---|---|---|---|---|---|
| | | 1 | 2 | 3 | 1 | 2 | 3 | 1 | 1 | 2 | 1 | 2 | 3 | 4 | 5 | | |
| No Plating Layer | 1 | 0.37 | 0.50 | 0.41 | 288 | 178 | 208 | 22 | 25 | 25 | 2.02 | 2.01 | 2.01 | 2.00 | 2.00 | 204 | 6.6 |
| | 2 | 0.21 | 0.21 | 0.41 | 154 | 197 | 287 | 13 | 10 | 10 | 1.95 | 1.95 | 1.96 | 1.98 | 1.98 | 210 | 7.4 |
| | 3 | 0.37 | 0.36 | 0.29 | 183 | 265 | 207 | 14 | 15 | 15 | 1.99 | 1.99 | 2.01 | 2.02 | 2.02 | 193 | 6.7 |
| | 4 | 0.34 | 0.39 | 0.28 | 136 | 197 | 292 | 12 | 15 | 10 | 1.96 | 1.97 | 1.97 | 1.99 | 1.99 | 210 | 6.8 |
| | 5 | 0.28 | 0.34 | 0.36 | 247 | 234 | 170 | 8 | 15 | 10 | 2.03 | 2.03 | 2.04 | 2.04 | 2.03 | 212 | 7.4 |
| | 6 | 0.17 | 0.36 | 0.30 | 217 | 244 | 217 | 14 | 10 | 10 | 2.00 | 2.01 | 2.00 | 2.00 | 2.00 | 190 | 7.0 |
| | 7 | 0.40 | 0.36 | 0.38 | 206 | 160 | 188 | 9 | 20 | 25 | 2.00 | 2.01 | 2.01 | 2.02 | 2.02 | 210 | 7.3 |
| | 8 | 0.40 | 0.37 | 0.30 | 337 | 189 | 217 | 9 | 5 | 15 | 2.01 | 2.00 | 2.00 | 2.00 | 2.01 | 215 | 7.1 |
| | 9 | 0.23 | 0.40 | 0.39 | 177 | 205 | 219 | 17 | 15 | 10 | 2.01 | 2.00 | 1.99 | 1.98 | 1.98 | 196 | 7.2 |
| | 10 | 0.30 | 0.30 | 0.44 | 254 | 190 | 199 | 31 | 40 | 35 | 2.03 | 2.03 | 2.03 | 2.02 | 2.03 | 206 | 7.3 |

### [Table 2]

**Table 2**

| | Example | Ra (µm) | | | Rsm (µm) | | |
|---|---|---|---|---|---|---|---|
| | | 1 | 2 | 3 | 1 | 2 | 3 |
| With Plating Layer | 1 | 0.64 | 0.67 | 0.74 | 81 | 82 | 84 |
| | 2 | 0.68 | 0.70 | 0.66 | 84 | 69 | 99 |
| | 3 | 0.52 | 0.69 | 0.75 | 62 | 71 | 66 |
| | 4 | 0.62 | 0.65 | 0.58 | 68 | 66 | 90 |
| | 5 | 0.65 | 0.78 | 0.71 | 67 | 70 | 97 |
| | 6 | 0.70 | 0.58 | 0.61 | 82 | 72 | 76 |
| | 7 | 0.66 | 0.80 | 0.60 | 77 | 99 | 79 |
| | 8 | 0.75 | 0.79 | 0.73 | 65 | 76 | 80 |
| | 9 | 0.71 | 0.66 | 0.62 | 65 | 80 | 64 |
| | 10 | 0.82 | 0.74 | 0.71 | 73 | 74 | 75 |

It was found that, the heat dissipation members according to Examples 1 to 10 have a lower thermal expansion coefficient than aluminum or copper, a small thickness, and excellent heat dissipation characteristics, and thus are suitably used for a heat dissipation member for automobile mount.

The present application claims priority based on Japanese Patent Application No. 2021-164570 filed on October 6, 2021, the entire content of which is incorporated herein by reference.

### REFERENCE SIGNS LIST

- 1:: heat dissipation member
- 2:: metal-silicon carbide composite
- 3:: metal layer
- 3A:: main surface
- 3B:: back surface

## Claims

1. A heat dissipation member comprising a flat metal-silicon carbide composite containing aluminum,
wherein a thickness of the heat dissipation member is equal to or less than 4 mm, and
the heat dissipation member is used as a heat dissipation member for automobile mount.

2. The heat dissipation member according to claim 1,
wherein when seen from a direction perpendicular to a main surface, vertical and horizontal lengths are equal to or less than 200 mm × equal to or less than 150 mm.

3. The heat dissipation member according to claim 1 or 2,
wherein an arithmetic mean roughness Ra in a main surface is equal to or more than 0.1 um and equal to or less than 2.0 µm.

4. The heat dissipation member according to any one of claims 1 to 3,
wherein an average length Rsm of roughness curve elements in a main surface is equal to or more than 50 um and equal to or less than 400 µm.

5. The heat dissipation member according to any one of claims 1 to 4,
wherein a flatness in a main surface is equal to or more than 5 um and equal to or less than 700 µm.

6. The heat dissipation member according to any one of claims 1 to 5,
wherein an amount of warpage is equal to or more than 5 um and equal to or less than 700 µm.

7. The heat dissipation member according to any one of claims 1 to 6, further comprising:
a plating layer that is formed on a main surface side of the heat dissipation member.

8. The heat dissipation member according to claim 7,
wherein an arithmetic mean roughness Ra in a surface of the plating layer is equal to or more than 0.1 um and equal to or less than 2.0 µm.

9. The heat dissipation member according to claim 7 or 8,
wherein an average length Rsm of roughness curve elements in a surface of the plating layer is equal to or more than 50 um and equal to or less than 400 µm.

10. The heat dissipation member according to any one of claims 7 to 9,
wherein the plating layer is formed of a Ni plating layer.

11. The heat dissipation member according to any one of claims 1 to 10, further comprising:
a metal layer that is formed on a main surface of the heat dissipation member and contains aluminum.

12. The heat dissipation member according to any one of claims 1 to 11,
wherein an average thermal expansion coefficient of the heat dissipation member at 25°C to 150°C is equal to or more than 4 ppm/K and equal to or less than 12 ppm/K.

13. The heat dissipation member according to any one of claims 1 to 12,
wherein a thermal conductivity of the heat dissipation member in a plate thickness direction at 25°C is equal to or more than 150 W/m·K and equal to or less than 300 W/m·K.
